# EUROPEAN PATENT APPLICATION

(11) **EP 4 016 594 A1**
(43) Date of publication of application: **22.06.2022**
(21) Application number: 20214042.2
(22) Date of filing: 15.12.2020
(51) Int. Cl.: H01L 21/66, H01L 21/78, H01L 25/00, H01L 33/00

(54) **METHOD AND SYSTEM TO PRODUCE DIES FOR A WAFER RECONSTITUTION**

(71) Applicant: Micledi Microdisplays BV, 3001 Leuven (BE); Imec VZW, 3001 Leuven (BE)
(72) Inventor: BEYNE, Eric, 3001 Leuven (BE); REBIBIS, June Kenneth, 3001 Leuven (BE); MILLER, Robert, 3001 Leuven (BE); STEUDEL, Soeren, 3050 Oud-Heverlee (BE); VERTOMMEN, Johan, 3220 Holsbeek (BE)
(74) Representative: Körfer, Thomas

(57) **Abstract**

A method is provided to produce dies for a wafer reconstitution. The method comprises steps of inspecting an epitaxial wafer (901) to detect one or more defects, overlaying a dicing scheme (902) on the epitaxial wafer (901) with the detected defects, classifying the dies in the dicing scheme (902) as good dies (903) or bad dies (904), and dicing the good dies (903) and transferring the good dies (903) onto a carrier wafer or a target wafer to wafer reconstitution.

## Description

The invention relates to yield improvement in wafer reconstitution techniques that are suitable for any applications that require a device to be made with the compound semiconductor that is tightly co-integrated with an integrated circuit.

Applications, whereby the specific material properties of the compound semiconductor are utilized can be either photo-emissive (e.g. LED display, VECSEL arrays), photosensitive (e.g. NIR imager, UV imager); a combination of both (e.g. light-emitting and/or photodetection for optical communication or neurostimulation) or electrical properties (transistors and diodes for power and/or highfrequency switches).

A possible application of this invention is a micro light-emitting diode display for augmented reality applications. The demand for a full high definition (FHD) or higher resolution display has increased. The FHD display requires a very large die size with a very tight pixel pitch.

An assembly technology to realize displays by using a light-emitting diode (LED) with direct bandgap III-V, III-N, or III-P material is known for example from EP 3 667 745 A1. This document shows light-emitting diodes reconstituted over a carrier substrate. One or more LED devices as a compound semiconductor stack are reconstituted over the carrier substrate. The LED devices may include a LED array or micro-LED array. However, defects on the epitaxial wafer can significantly impact the display devices made from the epitaxial wafers. Any defects or particles that cannot be removed will result in yield loss. To produce the large dies require stringent yield control. This in turn will drive the cost and impact manufacturability. Moreover, this is a multi-dimensional engineering challenge.

Accordingly, an object of the present invention is to provide a method, a system, and a wafer to produce dies for a wafer reconstitution with high yield, especially to maximize the number of useable dies produced from the epitaxial wafer by addressing the aforementioned limitations.

The object is solved by the features of the first independent claim for the method, by the features of the second independent claim for the system, and by the features of the third independent claim for a reconstituted wafer using the dies. The dependent claims contain further developments.

According to a first aspect of the invention, a method produces dies for a wafer reconstitution. The method comprises a step of inspecting an epitaxial wafer (also known as epi-wafer) to detect one or more defects. The method further comprises overlaying a dicing scheme on the epitaxial wafer with the detected defects. Further, the method comprises the step of classifying the dies in the dicing scheme as good dies or bad dies. Further, the method comprises the step of dicing the epitaxial wafer and transferring the good dies onto a target or carrier wafer. The invention aims to improve the quality of an epitaxial layer at the wafer level. Further, the invention aims at increasing the number of epitaxial layers or good dies from each epitaxial wafer.

Therefore, the proposed solution addresses the problem at the wafer level itself and maximizes the use of the epitaxial wafer by taking into account the defects present on the epitaxial wafer.

Preferably, the method further comprises the step of adjusting the dicing scheme with respect to the defects to optimize the location of the dies relative to the detected defects to yield a maximum number of the good dies from the epitaxial wafer. The dicing scheme can strategically be positioned in a manner that most defects are outside the dies. Preferably, the defects are positioned on the edges of each dies. Thereby increasing the number of good dies each epitaxial wafer can obtain.

Advantageously, the method further comprises the step of inspecting the epitaxial wafer by optical and/or electrical techniques. Advantageously, the defects can be detected by optical techniques such as spectroscopic or microscopic techniques. Mapped images of the defects on the epitaxial wafer can also be optionally used for future references. The defect mapping on the epitaxial wafer may preferably be used for machine learning or for automatization of the defect determination and classification process.

Preferably, the method comprises the step of selecting the good dies based on a density of the detected defects and/or location of the detected defects with respect to the dicing scheme and/or selecting the good dies based on optical properties of the dies as measured by photo luminance or cathode luminesces for all selected dies or a combination thereof and/or selecting the good dies based on film roughness, film thickness, film chemical composition, or a combination thereof. These selection criteria help to improve the yield. The film (epitaxial layer) properties can be measured such as roughness by AFM or interference, film thickness by ellipsometer, a chemical composition by Raman or infrared spectroscopy.

Preferably, the inspection on the epitaxial wafer can be performed in two steps: one step on the pristine as received epitaxial layer to detect defects that may no longer be visible post-processing and a second step after processing to detect defects on the bonding layer or composition.

Advantageously, the method further comprises the step of starting with a non-functionalized wafer or a non-structured or a blank epitaxial wafer. Advantageously, the epitaxial wafer has an epitaxial layer of III-V, III-N, or III-P material on a substrate. In other words, the epitaxial wafer is without any circuits on it and merely has the epitaxial layer. Commonly, the epitaxial layer is also known as the epi-layer.

The epitaxial layer may be grown by metal-organic chemical vapor deposition (MOCVD), molecular beam epitaxy (MBE), or any suitable techniques. Preferably, the substrate may be sapphire, GaAs, Ge, or more preferably silicon or any other suitable substrate. Advantageously, measuring the defects on the blank epitaxial wafer will allow characterizing the defects already at the wafer level. Therefore, the method of the invention allows optimizing of the dicing scheme position with respect to the detected detects over the epitaxial wafer to increase the number of the good dies yield per wafer.

Advantageously and preferably, the method comprises the step of dicing the epitaxial wafer by techniques such as mechanical dicing, plasma dicing, laser dicing, saw dicing, blade dicing, or stealth dicing. These dicing techniques allow the dicing of any dicing scheme applied over the epitaxial wafer.

Advantageously and preferably, the method further comprises the step of detecting the defects on the epitaxial wafer such as epi-layer defects, epi-pits, holes, slip line, cracks, particle, inclusion, protrusions, or a combination thereof.

Preferably, the good dies comprise a central region with zero defect tolerance, a peripheral region with high defect tolerance, and/or a middle region in between the central and the peripheral regions with low defect tolerance, and preferably wherein a pixel pitch greater than 3 µm tolerates in the high defect region in the range of 500 nm to 5µm size of defects and in the low defect tolerance range tolerates defects size of 300nm to 500 nm.

Further advantageously the method further comprises the step of transferring the good dies can be either (a) individually to a target wafer or (b) collectively via an intermediate carrier wafer.

According to the present invention, the carrier wafer is temporarily used and is not part of a reconstituted wafer. The carrier wafer is used to only transfer the good dies to the target wafer. Whereas the target wafer forms a part of the reconstituted wafer.

Preferably, the method (a) comprises the step of transferring the individual good dies to the target wafer. The method of transfer may be a direct pick and place transfer or any other suitable transfer method. Whereby the bonding layer preferably is inorganic layers such as SiCN or SiO₂ or any known bonding material. During the transfer, additional cleaning and inspection steps on the individual epitaxial die may be optionally performed before bonding.

Alternatively, the method (b) comprises the step of transferring the epitaxial dies collectively via the carrier wafer comprises transferring the good dies onto the carrier wafer via a temporary bonding layer. Optionally, cleaning and/or inspection steps on individual dies before the bonding may be performed. The method (b) further comprises the step of collectively transferring the good dies from the carrier wafer to a target wafer via a bonding layer. The carrier wafer is de-bonded. The good dies are distributed across the target wafer to forms a reconstituted wafer.

Advantageously and preferably, the method further comprises the step of fully or partially removing the substrate of the good dies at different stages, one option while they are bonded to the target wafer to expose a defect-free epitaxial layer, filling gaps between defect-free epitaxial layers, and planarizing to form the plurality of defect-free epitaxial dies (or also know as epi-dies or dies) distributed across the wafer. Preferably, the method further comprises the step of forming a display device on the reconstituted wafer and by a wafer-to-wafer (W2W) bonding of the reconstituted wafer onto a further wafer.

The further wafer comprises electronic devices, especially transistors, preferably CMOS-transistors, for driving and/or controlling electro-luminescent diodes made by structuring the epitaxial wafer. The further wafer advantageously can be a CMOS wafer.

Advantageously and preferably, the dicing scheme can be optimized in a manner to produce good dies with zero defects for the central region whereas the peripheral region and/or the middle region may still have limited defects according to the defectivity criteria.

Advantageously and preferably, the method further comprises the step of overlaying the dicing scheme on the epitaxial wafer. The dicing scheme can be a regular rectangular grid or an irregular scheme. In order to improve the number of good dies, positions, and sizes of the detected defects are used to optimize the dicing scheme. This may results in the irregular dicing scheme because the dies are placed around the detected defects to yield more good dies. Each die, based on the application it will be used for, is positioned in a manner either not to overlap any detected defects or to overlap the detected defects only at the die edges. A customized dicing scheme may yield a combination of both the good dies with zero defects and the good dies with defects acceptable based on the defectivity criteria. Preferably, the customization of the scheme may start with part of the epitaxial wafer with the least defect, where more dies can be placed in a regular scheme as a starting point. Further preferably, to build the dicing scheme from the starting point, on encountering the detected defects, the dies may be shifted to avoid overlapping or only overlapping at the die edge. The dies may be shifted laterally in any direction in a manner to yield more number of good dies. The dies can form a continuous or a discontinuous scheme over the epitaxial layers comprising the maximum number of the good dies. Therefore, die-by-die customization would increase the yield of good dies significantly.

The suitable dicing scheme is chosen or customized in a manner to optimize that most of the defects are outside the dies. By doing so the dies per wafer yield will be significantly increased.

According to a second aspect of the invention, a system is provided to produce dies for a wafer reconstitution. The system comprises a processing means configured to inspect an epitaxial wafer to detect one or more defects. The processing means is further configured to overlay a dicing scheme on the measured defects of the epitaxial wafer. In this context, the processing means is configured to classify the dies as good dies or bad dies and the processing means is further configured to dice the epitaxial wafer using dicing means. Preferably, the processing means is further configured to automatically perform these steps. More preferably, the processing means may self-learn to improve the inspecting of the epitaxial wafer for defects, positioning of the dicing scheme, classifying the good or bad dies, dicing the epitaxial wafer to obtain the good dies. Optionally, the good dies can further be selected after dicing by a further inspection. Whereby the production of the good dies can be automated and improved over time by self-learning.

Preferably the dicing means can be a saw, a laser, a plasma, and so on.

Advantageously, the processing means is configured to map the detected defects on the epitaxial wafer. Further, the processing means is configured to test the properties of a display device fabricated using the good dies and to compare the defect map with the properties of the display device. Advantageously, it is possible to determine if the defects or the defectivity criteria used during the process result in unsatisfactory display properties. Whereby, the selection criteria for good dies can be further optimized. Further, the processing means can use this information to self-learn and improve the selection criteria for the good dies. In other words, the processing means can self-learn if all the dies passed as good dies also perform well in the display device. In case the properties of the display device are not meeting the expected standards, the defect maps corresponding to the used good dies can be checked in order to tune the selection criteria to improve the yield.

According to a third aspect of the invention, a reconstituted wafer comprises good dies and a target wafer. The good dies are selected from an epitaxial wafer and a plurality of the good dies are fixed on the target wafer to form the reconstituted wafer. Preferably, the good dies and/or the target wafer have or has a layer of SiCN or other bonding material to bond them together.

Therefore, the reconstituted wafer fabricated according to the present invention formed from the improved yield of the good dies is cost-efficient.

Preferably, the reconstituted wafer comprises good dies produced from the epitaxial wafer and fixed on the target wafer. The epitaxial wafer comprises an epitaxial layer on a substrate. The epitaxial layer is III-V, III-N, or III-P layer material. Besides, the target wafer is a silicon wafer or other suitable material. Further, the substrate of the epitaxial wafer can be of sapphire, silicon, or any other suitable material.

Advantageously, the reconstituted wafer is suitable for a wafer-to-wafer hybrid bonding with a further wafer to form a display device. Preferably, the bonding is anodic or fusion bonding or preferably metal-to-metal bonding or any available wafer to wafer bonding. Whereby it is possible to achieve a large die area with a tight pixel pitch range. Preferably, fabrication of the display device using wafer-to-wafer hybrid bonding enables achieving a pixel pitch range below 3µm. Hence, the reconstituted wafer according to the present invention meets the requirements to be used for fabricating the FHD display.

Exemplary embodiments of the invention are now further explained with respect to the drawings by way of example only, and not for limitation. In the drawings:
- Fig. 1: shows a flow diagram with possible routes to integrated LED with a CMOS wafer;
- Fig. 2: shows an example of particle level of GaN LED epitaxial layer on (a) a sapphire wafer, (b) a silicon wafer, and (c) a plot of particle count for both sapphire and silicon;
- Fig. 3: shows an example of SEM images of growth defects on top of GaN LED epitaxial layer: (a) Epi pits, (b) slip line, (c) particle, and (d) inclusion;
- Fig. 4: shows an example of a luminance image of an epitaxial wafer by (a) photo luminance and (b) cathode luminance techniques;
- Fig. 5: shows an example of a plot of III-V epi-layer on-chip yield versus the die size for a standard CMOS, GaN on Si (A+ and BB), AllnGaP on GaAs, and GaN on Sapphire;
- Fig. 6: shows an exemplary embodiment of a flow chart to produce good dies for a wafer reconstitution and fabricate a device using a reconstituted wafer;
- Fig. 7: shows an exemplary embodiment of defect inspection of GaN on Si-wafer: (a) Defect inspection map and defect classification into different categories, (b) overlay dicing scheme over the GaN on Si-wafer, and (c) mark the bad dies as x;
- Fig. 8: shows an exemplary embodiment of an overlay the die of the CMOS wafer and the good epi die;
- Fig. 9: shows an exemplary embodiment of dicing schemes (a) a standard rectangular grid, (b) an optimized rectangular grid, and (c) an irregular dicing scheme;
- Fig. 10: shows a system for producing dies for a wafer reconstitution;
- Fig. 11: shows an exemplary embodiment of a flow chart to produce a wafer reconstitution using a carrier wafer or directly on a target wafer;
- Fig. 12: shows an exemplary embodiment of the method for wafer reconstitution: (a) Bonding epitaxial dies over a carrier substrate, (b) filling the gaps between the dies and planarizing, and (c) a reconstituted wafer; and
- Fig. 13: shows an exemplary embodiment of an integration schematic starting with an epitaxial wafer and a carrier wafer up to microLED display using wafer-to-wafer bonding.

Reference will now be made in detail to embodiments of the present invention, examples of which are illustrated in the accompanying drawings. However, the following embodiments of the present invention may be variously modified and the range of the present invention is not limited by the following embodiments.

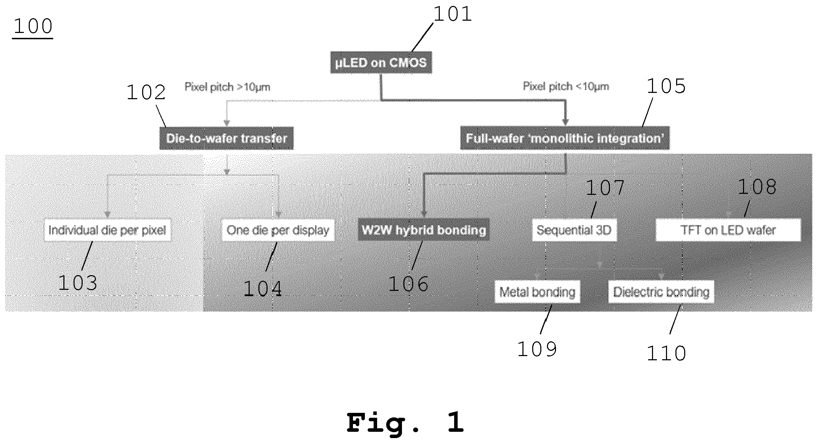

In this invention, references are made to different types of wafers, which are defined here. The epitaxial wafer refers to the wafer with a blanket film or non functionalized wafer. The epitaxial wafer can be referred to as epi-wafer. A carrier wafer refers to the wafer used for the transfer of good dies (or epi dies) on to a target wafer. The carrier wafer is a temporary wafer used in an optional process step. The carrier wafer does not form a part of a reconstituted wafer. A target wafer is a final wafer on which the good dies are transferred and bonded. The target wafer is a part of the reconstituted wafer. A further wafer comprises electronic devices, especially transistors, preferably CMOS transistors for driving and/or controlling electro-luminescent diodes. In Fig. 1, the possible routes to integrate microLED with a further wafer 100, wherein the further wafer comprises electronic devices, especially transistors, preferably is a CMOS wafer.

The next-generation applications of microLED displays require a very tight pixel pitch of 3 µm or less and very large arrays in order to realize the full high definition (FHD) of 1920 × 1280 pixels. Fig. 1 illustrates possible routes to achieve microLED on CMOS 101. By a die-to-wafer transfer 102, it is possible to achieve a pixel pitch over 10µm with one die per pixel 103 with RGB dies and one die per display 104 with B+RG down conversion or RGB by separate dies and combiner. However, the FHD display requires a much lower pixel pitch range. The pixel pitch less than 10µm may be achieved by a full wafer monolithic integration 105.

For example, the required number of the pixel for the FHD display will automatically translate to a very large die size of area 6 mm × 4mm (with 3µm pitch). This in turn will result in stringent yield requirements. Therefore, wafer-to-wafer 106 is a promising method while using full-wafer monolithic integration. This allows achieving tight pixel pitch over a large die size, preferably 3µm or lower.

The challenges faced during the preparation of the epitaxial wafer can be due to several reasons such as growth conditions, growth methods, growth temperature, or temperature ramp. These results in the epitaxial wafer with unavoidable defects.

The compound semiconductor for LED is commonly grown by an epitaxial process on a foreign substrate (hetroepitaxy), which is closely lattice-matched. The growth technique can be Molecular Beam Epitaxy (MBE) or more commonly Metal-Organic Chemical Vapor Deposition (MOCVD). The epitaxial wafer for the present invention can for example be III-V, III-N, or III-P epitaxial LED layer. The defectivity level of the epitaxial layer is significantly higher than the Si-CMOS wafer. Since the defects in the epitaxial wafer are inevitable, there is a need for methods to work around the defects to improve the yield.

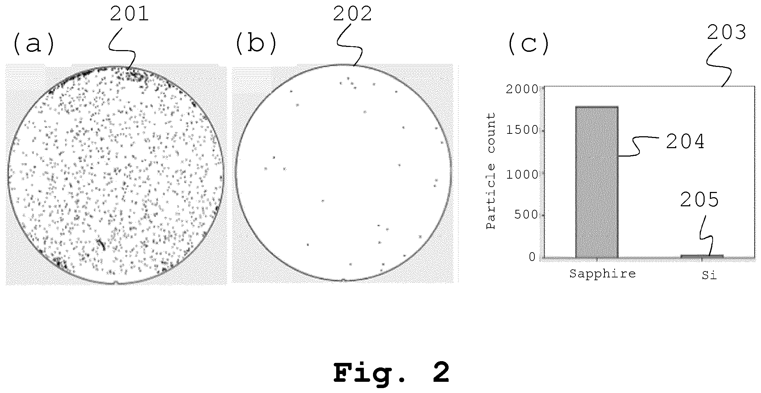

Some of the reasons for the defects on the epitaxial wafer are discussed. The first reason for the defects is the use of a less perfect substrate. Sapphire is preferred as it provides a good lattice match, however, results in a significantly large number of defects. Fig. 2(a) and 2(b) show the defect level of the GaN LED epi layer on a 150 mm sapphire wafer 201 and a 200 mm Si-wafer 202, respectively. A sapphire substrate results in a higher defect count than a Si-substrate. Fig. 2(c) shows a particle count plot 203 for both sapphire 204 and Si-wafer 205. The particle count for sapphire 204 is for example 1784 whereas for Si 205 it is only about 29 for the same size. Therefore, the challenge in using a sapphire epitaxial wafer is to improve the yield to make the choice cost-effective.

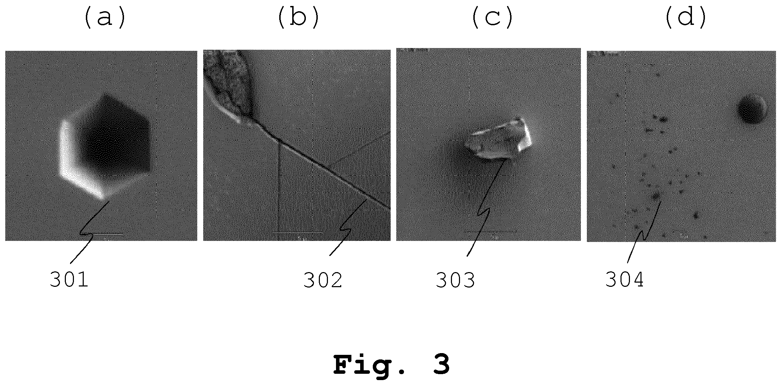

The second reason for the defects may be attributed to the growth technique of the epitaxial layer, especially MOCVD. MOCVD often still uses manual wafer loading techniques, often outside the cleanroom. Furthermore, MOCVD chambers are generally not optimized for defectivity but throughput. To increase throughput, MOCVD has multi-wafer deposition chambers, stainless steel growth chamber, and far less sophisticated chamber cleaning process or cleaning gases compared to advanced Si-CMOS CVD chambers. The need for multi-wafer deposition is driven by the very long deposition time and heat ramp time of several hours for a few micrometers thick film at a temperature between 700 and 900°C making a single wafer deposition chamber uneconomical. Consequently, growth defects on the epitaxial wafer become inevitable. In addition, growth defects can also occur due to lattice mismatches such as epi pits or slip lines during the growth process. Some examples of the growth defects on top of a GaN LED epi-layer are shown in Fig. 3. The SEM images in Fig 3(a)-(d) are epi-pits 301, slip line 302, particle 303 and inclusion 304, respectively.

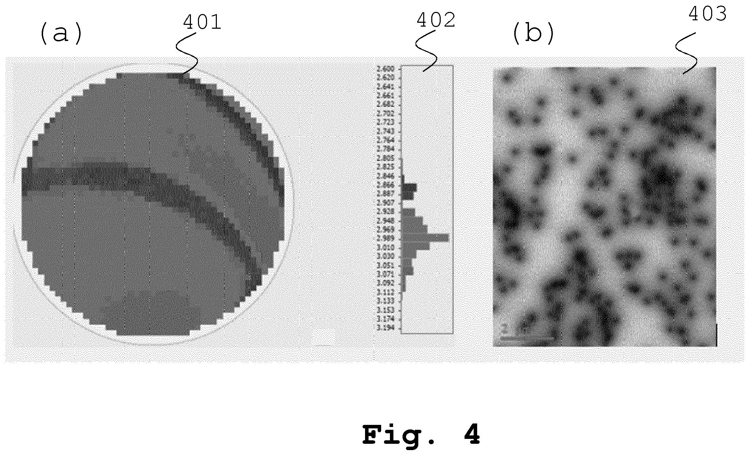

The third possible reason is associated with the epitaxial layer deposition uniformity, which especially affects the final display properties. The epi-layer uniformity can influence the global uniformity of the display device in terms of peak wavelength, Internal Quantum Efficiency (IQE), and/or the local uniformity. Fig. 4 (a)-(b) show the uniformity measurement maps of the epitaxial layer by (a) photo luminance 401 and (b) cathode luminance 403, respectively. The photo luminance map 401 shows the characteristic emission from the epitaxial layer. The uniformity across the epitaxial wafer can readily be identified from the luminance map. Further, the intensity distribution plot 402 corresponding to the photo luminance map 401 also reflects the uniformity of the layer. These luminance methods can be used to explore scattering, electronic structure of materials such as band gaps, defects, resonant phenomena, and much more. In that context, a cathode luminance map 403 also reflects the defects of the epitaxial layer.

The fourth reason for low yield can be explained by the bonding method used to bond the CMOS wafer with the epitaxial wafer. If the CMOS wafer is bonded with epitaxial LED wafer by wafer-to-wafer transfer, a very high yield of the CMOS wafer can be assumed depending upon the die size with a standard defect density of 0.1 cm⁻². However, the defect density of the epitaxial wafer is 10-100 times higher than the standard value, meaning the III-V epi-layer will significantly limit the yield during manufacturing.

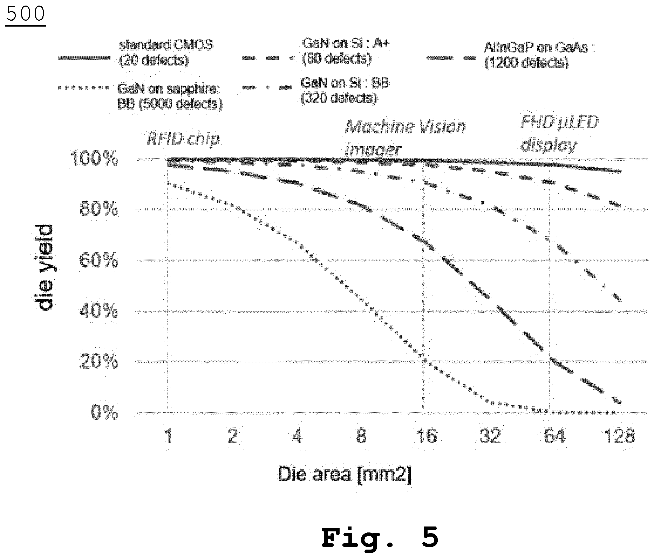

In Fig. 5, the impact of the high defect density in III-V epi-layer on-chip yield is plotted versus the die size 500. Here it is assumed that any particle or epi-defect is large than 0.3 µm would create a non-working pixel. Of course, for the final product, the acceptable defectivity on the pixel level may vary. The standard defectivity level in mobile phones is zero defects per display, whereas in monitors or televisions commonly 3-6 non-working pixels that do not light up and are not clustered together per one million pixels may be accepted. For Fig. 5, the mobile phone defect level is used.

In Fig. 5, even the best GaN on Si epi-wafer shows a significant yield loss relative to CMOS. For the FHD display, the die area is significantly larger, therefore, the die yield significantly drops as shown in the plot. In reality, the defectivity is even worse since the standard wafer inspection data excludes defects close to the edge (edge exclusion between 2 and 10mm) where there is an especially high defect count due to the slip lines emanating from the bevel of the wafer. These will not be relevant for the individual die yield, however, can cause a complete failure of in W2W bonding process.

The fifth reason that impacts yield is the high wafer bow of III-V wafer due to the intrinsic stress. The III-V material is lattice-matched by growing at a very high temperature and when the wafer cools down the expansion coefficient of the epi-layer is different from the substrate causing a wafer bow. To reduce the wafer bow, the thermal chuck on which the substrate wafer rests is not flat but pre-shaped to over-compensate for the stress-induced bow. This technique works very well for GaN on Si wafer but is not very efficient for the sapphire wafer.

The LED industry has learned to work with the high wafer bow since the structural dimension is not very critical. However, this is a significant problem if the III-V epi wafer needs to be processed in a CMOS fabrication facility, where the tools do not accept wafer with more the 45 µm of wafer bow. If the critical dimension gets much smaller, the wafer bow criteria get even more stricter, since, the wafer bow can affect the uniformity of process steps like litho, CMP, dry-etch. This means, the III-V epi wafer needs to be pre-selected and only a certain percentage of the selected wafer can be used for further processing. Hence, the yield is influenced by the wafer bow.

The present invention provides a method and a system to produce dies for a wafer reconstitution by overcoming all the drawbacks and provides a high yield.

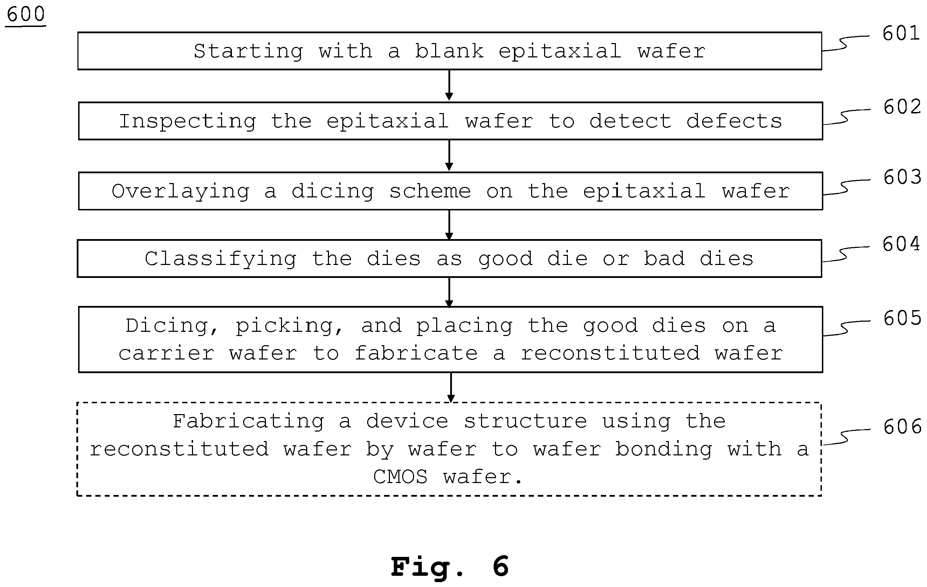

According to the present invention, the first exemplary embodiment of the method according to the first aspect is illustrated in Fig. 6 with an exemplary flow diagram 600. The flow diagram illustrated the steps involved to improve the yield to produce good dies. Starting with a blank epitaxial wafer without any structure for electrical functionality is highly advantageous to achieve the high yield 601. The method comprises the step of inspecting the epitaxial wafer to detect one or more defects 602. The method further comprises the step of overlaying a dicing scheme on the epitaxial wafer with the detected defects 603. The method further comprises the step of classifying the dies of the overlaid dicing scheme as good dies or bad dies 604. The method further comprises the step of dicing the epitaxial wafer and transferring the good dies onto either directly on a target wafer or transferring the good dies to a carrier wafer and then eventually to a target wafer, thereby fabricating a reconstituted wafer 605. Therefore, the invention provides a method to work around the defects of the epitaxial wafer at the wafer level to improve the yield of the good dies for the wafer reconstitution.

For example, silicon-substrate is used for a target wafer provided. Preferably, a layer of SiCN may be applied to the target wafer in order to create a bonding surface. More preferably, the selected good dies may also be covered with a SiCN layer. Advantageously, SiCN offers a high bonding strength between the good dies and the target wafer. Further, in order to improve the bonding strength, a post-bond annealing process may be performed. Therefore, the good dies can be picked and placed on the target wafer and bonded via the SiCN layer. Optionally, one or more SiN layers or alternative dielectric layers can be provided as an intermediate layer between the target wafer surface and the SiCN layer. Further, optionally, the flatness and roughness can be improved by polishing these intermediate layers.

In addition to the above-mentioned steps, Fig. 6 also shows the step of fabricating a device structure using the reconstituted wafer 606, which is made according to the inventive method. In an exemplary embodiment of the first aspect of the invention, the inspection is done on a non-functionalized wafer, non-structured wafer meaning a blank wafer as the epitaxial wafer with an epitaxial layer. Consequently, the yield of the display device can already be improved at the beginning of the fabrication process.

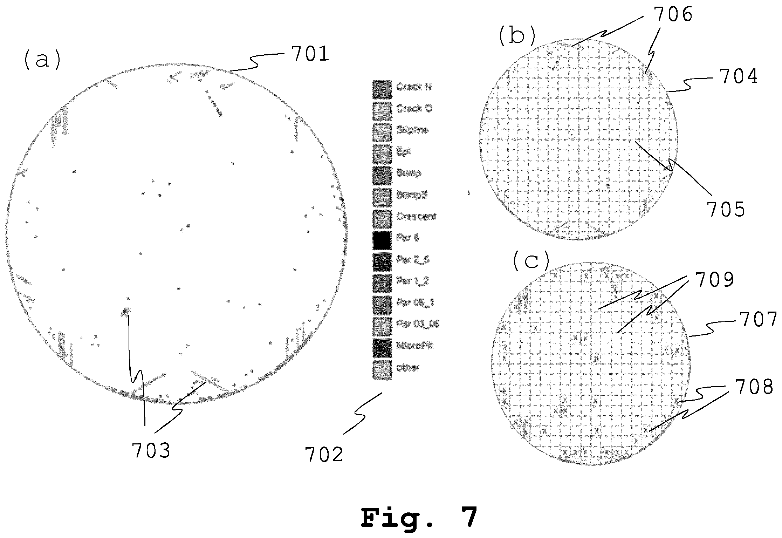

Fig. 7 shows the defect inspection map of the epitaxial wafer 701, overlaying the dicing scheme on the epitaxial wafer, and classifying the good dies 709. The possible defects 703,706 on the epitaxial wafer 701,704 can be determined by inspection. The inspection can be done, for example, by microscopic or spectroscopic techniques. Several defects 703,706 such as cracks, slip lines, epi pits, or bumps can be determined during the inspection. Alternatively or additionally, non-destructive electrical techniques may be used.

As an example, Fig 7(a) shows a defect inspection map 701 of a 200 mm GaN on Si-wafer carried out by the KLA Circl inspection tool. The defects 703 are classified into different categories 702. To determine the good dies 709, a dicing scheme 705 is overlaid on the epitaxial wafer 704 with the detected defects 706 as in Fig. 7(b). As an example, the dicing scheme 705 is a rectangular grid overlaying the Si-wafer. In Fig. 7(c) the parts of the dicing grid 705 directly over the defects 703, 706 are classified as bad dies 708, which are marked as 'x' in the example. The squares without a 'X' mark are locations for good dies 709.

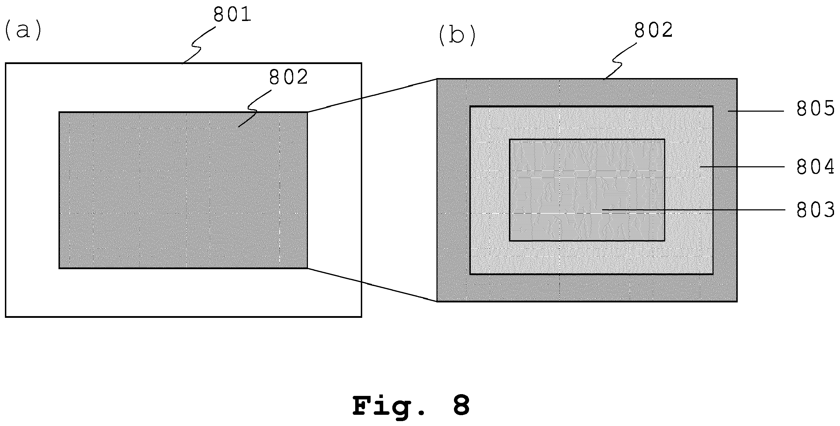

In Fig. 8 a further exemplary embodiment of the method according to the first aspect of the invention is illustrated. The method to further improve the yield of good dies comprises the step of adjusting the dicing scheme with respect to the defects to optimize the location of the dies relative to the detected defects to yield a maximum number of the good dies from each of the epitaxial wafers. In other words, considering the size and location of the defects on the epitaxial wafer with respect to each square or rectangle of the dicing scheme.

Fig. 8 shows an overlay of the die of the CMOS wafer and the good epi die. The defectivity criteria for the III-V epitaxial die area (also known as epi-die) are illustrated in Fig. 8 with different regions. The quality of the dies will directly affect the device structure fabricated with it such as the microLED display. In general, for the reconstituted wafer bonded to the CMOS wafer, an active CMOS area 801 will be larger than the epi die 802 and the emissive area of the of the epi die 803 and 804. The area between 801 and 802 takes into account the required IO and additional controlling and computation. For most applications, very large defects should be avoided since it will influence the overall yield, especially during bonding of the reconstituted wafer to the CMOS wafer. However, depending on the application, defectivity criteria may vary (e.g, for zones 802, 803, and 804).

Based on the application, the area occupied by the III-V material (i.e., the good die) can be segmented by considering the impact of the defects on the yield. The defectivity criteria for each segment of the III-V epi die area 802 is illustrated in Fig. 8. The epitaxial die may have three segments as shown in Fig. 8(b). The segments are a central region 803, a middle region 804, and a peripheral region 805. The central region 803 of the III-V epi-die area must have zero-defect. The middle region 804 surrounding the central region 803 may have a low number of defects, especially for the near-eye display. This is because the resolution of the eye is better in the center and drops towards the outside of the field of view.

Finally, a peripheral region 805 surrounding the middle region is a non-emissive exclusion zone, which can tolerate a higher number of defects compared to the middle region 804. Therefore, any acceptable un-uniformity or acceptable good dies with minor defects can be placed away from the emissive area (the central and the middle regions). Thus, the defectivity criteria allow good dies with zero defects, and further some good dies to contain acceptable defects. The dicing scheme is overlapped in a manner the good dies with zero defects, the good dies with defects in the range 300 nm to 500 nm, and good dies with defects in the range 500 nm to 5 µm can be obtained. Although the good dies with zero defects are preferred, the good dies with acceptable defects can still be used in the epitaxial die area. Since the defectivity criteria allow room for defects, it is possible to optimize the location of the good dies relative to the detected defects to yield the maximum number of the good dies from the epitaxial wafer. Therefore, the use of a less perfect substrate such as sapphire would still be economical.

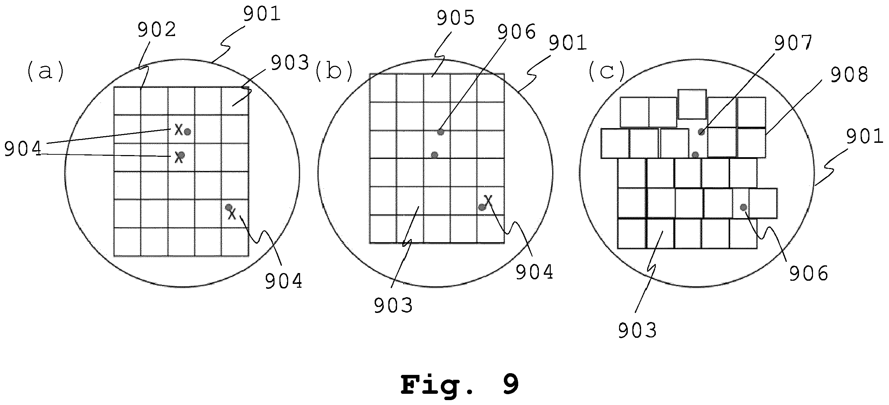

In Fig. 9, a third exemplary embodiment of the method according to the first aspect of the invention is illustrated. As an example, different dicing schemes 902,905,908 overlaid on the epitaxial wafer 901, are shown in Fig. 9 (a)-(c), respectively.

Fig. 9(a) shows a standard non-optimized dicing scheme 902 with a regular rectangular grid 902. The dies that overlap the detected defects are marked with 'x' 904. Optimizing the dicing scheme can improve the yield of the good dies. For example, Fig. 9(a) shows three bad dies.

Preferably, the defectivity criteria may be used to optimize the dicing scheme. Fig. 9(b) shows the optimized rectangular dicing grid in a manner to place the defects at the edges 906 of the die by satisfying the defectivity criteria. In Fig. 9(b), although a die 906 overlaps two defects, it could still be classified as a good die because the defects would lie on the peripheral region 805, which can tolerate higher defects. This results in only one bad die 904 in Fig. 9(b) whereas the standard method would produce three bad dies for a similar rectangular grid. Even if no defects are allowed, Fig. 9(b) has only two bad dies, which is still better than the dicing scheme used in Fig. 9 (a). Hence, optimizing the dicing scheme improves the yield of good dies even for the same scheme.

Further, any known dicing technique such as a saw, a high power laser, or a plasma can be used to dice a rectangular dicing grid of Fig. 9(a) and 9(b). As saw dicing is very economical this simple method has some advantages.

As a further embodiment to increase the number of good dies 903, the dicing scheme 908 is customized with respect to the defects 906 to optimize the location of the dies relative to the detected defects to yield a maximum number of the good dies 903 from the epitaxial wafer 901. This may invariably result in an irregular dicing scheme. The irregular dicing scheme 908 is preferably defined digitally die-by-die as shown in Fig. 9(c). Advantageously, the defectivity criteria are considered while customizing the dicing scheme.

The dicing technique used for any irregular scheme is preferably plasma dicing or laser dicing. The advantage of the irregular scheme is that defects can be avoided on the dies but the yield is still sufficient.

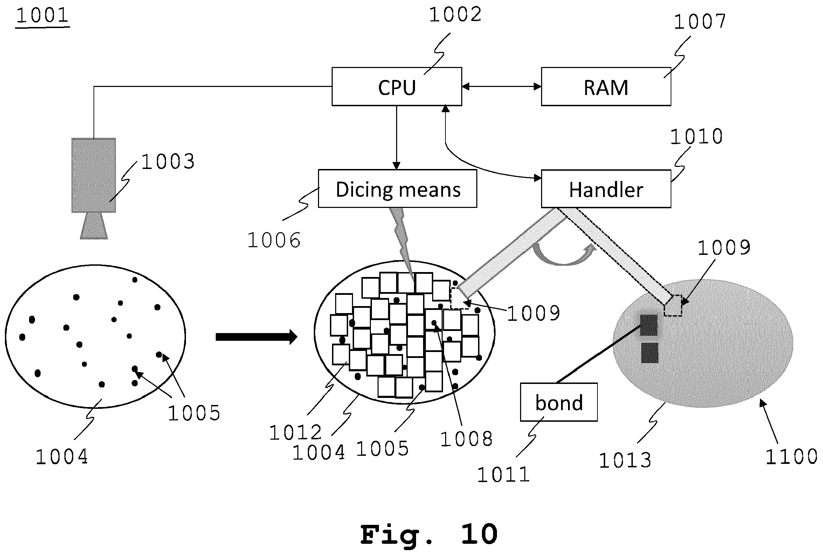

According to the second aspect of the invention, a system to produce dies for a wafer reconstitution is provided. This is shown in Fig. 10. The system 1001 comprises a processing means 1002 using inspection means 1003 configured to inspect an epitaxial wafer 1004 using inspection means 1003 to detect one or more defects 1005. The processing means 1002 is further configured to overlay a dicing scheme 1012 on the detected defects 1005 of the epitaxial wafer 1004. In this context, the processing means 1002 is configured to classify the dies as good dies 1009 or bad dies 1008. The processing means 1002 is further configured to dice the good dies by dicing means 1006. The good dies 1009 are transferred to the carrier wafer 1013 or target wafer by the handling means 1010 to form a reconstituted wafer 1100. Optionally, after dicing the good die verification can be repeated.

Preferably, the processing means 1002 is further configured to self-learn to detect the defects 1005, overlay a suitable dicing scheme, classify the dies as good dies 1009 or bad dies 1008, and/or dice the good dies 1009. Thereby, the production of the good dies 1009 can be automated.

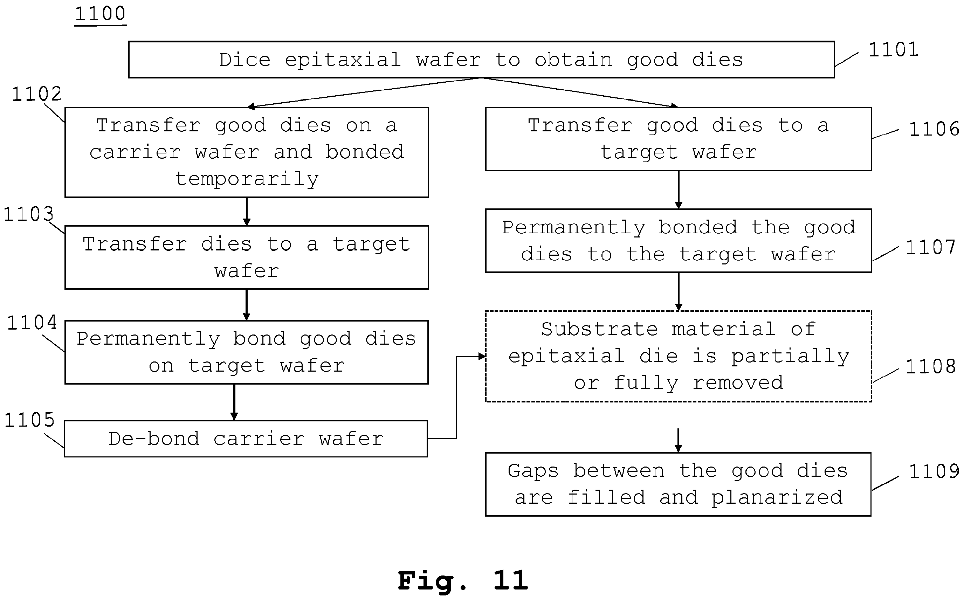

As a further embodiment of the second aspect of the invention, the processing means 1002 is configured to store a defectivity map in a memory 1007. When the final display device does not meet the standard requirements in terms of color, texture, resolution, emissivity, lifetime, etc., the saved defectivity map can be used to identify if any defects on the epitaxial wafer 1004 were passed as acceptable but later significantly affected the display. Thereby, the processing means 1002 can self-learn to improve the defect detection and/or the selection of the good dies 1009 and/or bad dies 1008. Therefore, the processing means 1002 can self-learn to classify good dies that can also perform well in the display device. According to an exemplary of the embodiment of the third aspect of the invention is illustrated in Fig. 11. After optimizing the dicing scheme over the epitaxial wafer, the epitaxial wafer is diced to obtain good dies 1101. Two different approaches are discussed here to transfer the good dies to the (final) target wafer.

According to the first approach, the good dies are transferred to a temporary carrier wafer and bonded by a temporary bonding method 1102. The carrier wafer can have different wafer size with respect to the epitaxial wafer. Many different integration approaches are possible with the carrier wafer such as pick and place good dies on the carrier wafer. The good dies are bonded to the carrier wafer via a temporary bond. The temporary bonding material keeps the good dies on the carrier wafer. All dies on the carrier wafer are collectively transfer to the target (final) wafer 1103. All good dies are permanently bonded to the target wafer by a bonding film such as SiCN, SiO₂ as in step 1104. The carrier wafer is debonded 1105. The permanent bonding of the good dies to the target wafer can be fusion, anodic, dielectric, metallic, or hybrid bonging.

According to the second approach, the good dies are directly transferred to a target wafer 1106. The good dies are bonded to the target wafer through any of the permanent bonding methods of the method (a).

According to either of these methods, the substrate material of the epitaxial wafer is removed fully or partially 1108. The removal of the substrate material of the epitaxial wafer can be at various stages such as prior to dicing, during dicing, while dies are on the carrier wafer, or while the dies are on a target wafer. The substrate removal methods may be mechanical grinding, wet etching, dry etching, or a combination thereof. Finally, after the good dies are on the target wafer by any one of the above methods forming the reconstituted wafer, the gaps between the good dies are filled and planarized 1109. This reconstituted wafer can be later bonded to a further wafer such as a CMOS wafer.

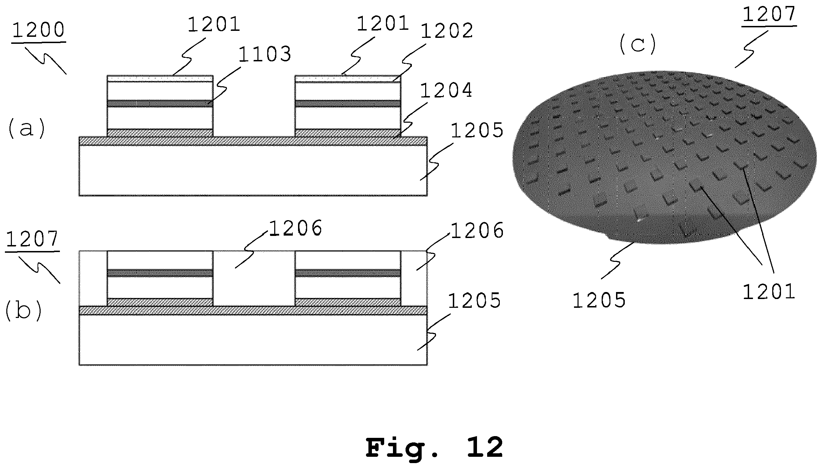

According to an exemplary embodiment of the third aspect of the invention is illustrated in Fig. 12. The method to produce the reconstituted wafer using the target wafer is route is illustrated. A reconstituted wafer 1200 comprises good dies 1201 formed from an epitaxial wafer 1004 (shown in Fig. 10) and transferred to a target wafer 1105 by handling means 1010 shown in Fig. 10. Accordingly, the good dies 1201 are bonded to the target wafer 1205 to a bonding layer 1204 by bonding means 1011 shown in Fig 10. For example, the bonding layer 1204 can be a SiCN or SiO₂ layer on the good dies 1201 and/or on the target wafer 1205.

Fig. 12(a) shows a target wafer 1205 with the two selected good dies 1201. The substrate 1202 of the good dies 1201 is removed by a suitable method to expose the epitaxial layers at this stage or may be removed at a different stage. Fig. 12(b) shows the schematics of gaps between these good dies 1201 are filled with filler 1206 and planarized to form a plurality of defect-free epitaxial layers distributed across the target wafer. Fig. 12(c) shows a planarized reconstituted wafer 1207. Therefore, the planarized reconstituted wafer 1207 has defect-free good dies 1201 distributed across the target wafer 1205 ready to be used with a further wafer such as CMOS wafer.

For example, the epitaxial wafer is a 150-200 mm silicon or sapphire wafer, and the target wafer is a 300 mm Si-wafer. Preferably, the filler to fill the gaps is SiO₂ or any other suitable dielectric material.

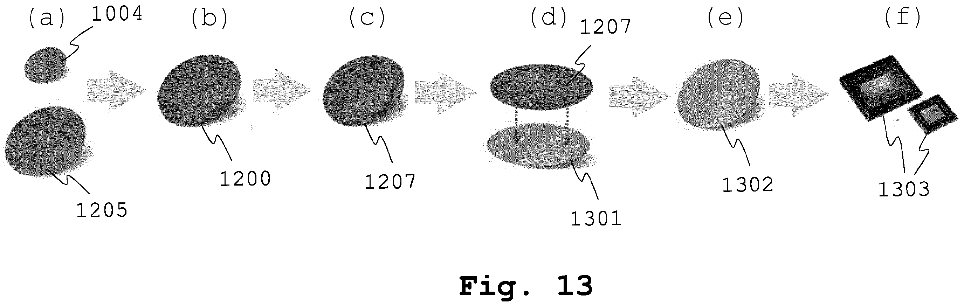

In Fig. 13, an overview of integration technology to form a microLED display starting from the epitaxial wafer is shown. The overview shows the fabrication of a reconstituted wafer according to the invention, transferring the reconstituted wafer on a CMOS wafer by wafer-to-wafer transfer, and fabrication of a microLED display.

Fig 13(a) shows an epitaxial wafer 1004 and a carrier wafer 1205. By the method of the present invention, the maximum number of good dies are produced from the epitaxial wafer 1004. These good dies are transferred onto the target wafer 1205. The good dies are arranged across the target wafer 1105 as shown in Fig. 13(b) . The gaps between the good dies are filled and planarized in order to provide the planarized reconstituted wafer 1207 as shown in Fig. 13(c).

The further method steps displayed in Fig. 13(d)-(f) show the fabrication of the microLED display using the planarized reconstituted wafer 1207 of the present invention.

Advantageously, the planarized reconstituted wafer 1207 allows the use of wafer-to-wafer hybrid bonding. As the required precision for the W2W bonding can be achieved with the reconstituted wafer 1207 of the invention. The reconstituted wafer 1207 is bonded to a CMOS wafer 1301 as shown in Fig. 13(d). For example, the CMOS wafer 1301 is a 300 mm CMOS wafer. Further, preferably the bonding is dielectric bonding or metal-to-metal bonding or hybrid bonding. The microLED display 1302 with wafer-to-wafer bonded LED array on the CMOS wafer is shown in Fig. 13(e). Finally, steps of dicing, packing, and testing are performed to achieve a display device 1203 as shown in Fig. 13(f).

Although the invention has been illustrated and described with respect to one or more implementations, equivalent alterations and modifications will occur to others skilled in the art upon the reading and understanding of this specification and the annexed drawings. Furthermore, while a particular feature of the invention may have been disclosed with respect to only one of several implementations, such feature may be combined with one or more other features of the other implementations as may be desired and advantageous for any given or particular application.

## Claims

1. A method to produce dies for a wafer reconstitution, the method comprising:
inspecting (602) an epitaxial wafer (701,901,1004) to detect one or more defects (703,706,904,906,907);
overlaying (603) a dicing scheme (902,905,908) on the epitaxial wafer (701,901,1004) with the detected defects (703,706,904,906,907);
classifying (604) the dies in the dicing scheme (902,905,908) as good dies or bad dies; and
dicing (605) the epitaxial wafer into dies and transferring (605) the good dies onto a target or a carrier wafer (1105).

2. The method according to claim 1,
wherein the method further comprises the step of adjusting the dicing scheme (902,905,908) with respect to the defects (703,706,904,906,907) to optimize the location of the dies relative to the detected defects (703,706,904,906,907) to yield a maximum number of the good dies from the epitaxial wafer (701,901,1004).

3. The method according to claim 1 or 2,
wherein the method further comprises the step of inspecting the epitaxial wafer (701,901,1004) by optical and/or electrical techniques.

4. The method according to any of claims 1 to 3,
wherein the method further comprises the step of selecting the good dies based on a density of the detected defects (703,706,904,906,907)and/or location of the detected defects with respect to the dicing scheme (902,905,908), and/or
selecting the good dies based on optical properties of the dies as measured by photo luminance or cathode luminesces for all selected dies or a combination thereof, and/or
selecting the good dies based on film roughness, film thickness, film chemical composition, or a combination thereof.

5. The method according to any of claims 1 to 4,
wherein the method further comprises the step of starting with a non-functionalized wafer or a non-structured wafer or a blank epitaxial wafer as the epitaxial wafer (701,901,1004), especially the epitaxial wafer (701,901,1004) with an epitaxial layer of a III-V, III-N, or III-P material on a substrate.

6. The method according to any of claims 1 to 5, wherein the method further comprises the step of dicing the epitaxial wafer (701,901,1004) by plasma dicing or laser dicing or blade dicing or stealth dicing.

7. The method according to any of claims 1 to 6,
wherein the method further comprises the step of detecting epi-layer defects, epi-pits defects (301), slip line defects (302), cracks, particle defects (303), or inclusion defects (304), or a combination thereof.

8. The method according to any of claims 1 to 7,
wherein the method further comprises the step of fixing the good dies onto the target wafer or the carrier wafer (1105) via bonding, preferably fusion bonding, direct bonding, anodic bonding, metal-metal bonding, or adhesive bonding.

9. The method according to one of claims 1 to 8,
wherein the method further comprises the steps of removing the substrate (1102) of the dies (701,901,1004) after fixing the good dies to the target wafer or the carrier wafer (1105) to expose the epitaxial layer,
filling gaps (1106) between the dies, and planarizing (1107) to form the plurality of defect-free dies distributed across the wafer.

10. The method according to any of claims 1 to 9,
wherein the method further comprises the step of forming a display device by a wafer-to-wafer bonding of the reconstituted wafer (1100) onto a further wafer,
wherein the further wafer comprises electronic devices, especially transistors, preferably CMOS-transistors, for driving and/or controlling electro-luminescent diodes made by structuring the epitaxial wafer (701,901,1004).

11. The method according to claim 10,
wherein the dies comprises a central region (803) with zero defect tolerance, a peripheral region (805) with high defect tolerance, and/or a middle region (804) in between the central and the peripheral regions with low defect tolerance, and
wherein for a pixel pitch greater than 3 µm the high defect tolerance range tolerates defects of 500 nm to 5µm and the low defect tolerance range tolerates defects of 300 to 500 nm.

12. The method according to any of claims 1 to 11,
wherein the dicing scheme (902,905,908) is a regular rectangular grid (902,905), or
wherein the dicing scheme is an irregular scheme (908) optimized in a manner that most of the defects are outside the dies.

13. A system (1001) to produces dies for a wafer reconstitution, the system comprises:
a processing means (1002);
wherein the processing means (1002) is configured to inspect an epitaxial wafer (1004) to detect one or more defects (1005) by inspection means (1003);
wherein the processing means (1002) is further configured to overlay a dicing scheme (902,905,908) on the measured defects of the epitaxial wafer (701, 901, 1004) ;
wherein the processing means (1002) is further configured to classify the dies as good dies (1009) or bad dies (1008); and
wherein the processing means (1002) is further configured to dice the good dies (1009) by dicing means (1006).

14. The system (1001) according to claim 13,
wherein the processing means (1002) is further configured to self-learn to detect the defects, to overlay dicing scheme (902,905,908), and/or to classify the dies as good dies (1009) or bad dies (1008), and/or
dice the good dies (1009).

15. The system (1001) according to any of claims 13 to 14,
wherein the processing means (1002) is configured to map the detected defects (1005) on the epitaxial wafer (701,901,1004),
wherein the processing means (1002) is further configured to test properties of a display device (1203) fabricated using the good dies (1009), and
wherein the processing means (1002) is configured to compare the map of detected defects (1005) corresponding to the properties of the display device (1203).

16. A reconstituted wafer (1100) comprising good dies (1009);
a target wafer or a carrier wafer (1105);
wherein the good dies (1009) are selected from an epitaxial wafer (701,901,1004);
wherein a plurality of the good dies (1009) is fixed or bonded on the target wafer or the carrier wafer (1005).

17. The reconstituted wafer (1100) according to claim 16,
wherein the epitaxial wafer (701,901,1004) is a heteroepitaxy wafer or blank wafer or non functionalized wafer,
wherein an epitaxial layer on the epitaxial wafer is a III-V, III-N, or III-P layer, and/or
wherein the carrier wafer (1005) is a silicon wafer or glass wafer, and/or
the reconstituted wafer (1100) is suitable for a wafer-to-wafer bonding with a further wafer to form a display device (1203), wherein the bonding is fusion bonding, anodic bonding or preferably dielectric binding or metal-to-metal bonding or adhesive bonding.
